# EUROPÄISCHE PATENTSCHRIFT

(11) **EP 2 315 236 B1**
(45) Veröffentlichungstag und Bekanntmachung des Hinweises auf die Patenterteilung: **14.05.2014**
(21) Anmeldenummer: 09173836.9
(22) Anmeldetag: 22.10.2009
(51) Int. Cl.: F16K 51/02, F16K 1/20, H01L 21/67

(54) **Klappen-Transferventil**
Flap transfer valve
Soupape de transfert à clapets

(43) Veröffentlichungstag der Anmeldung: 27.04.2011
(73) Patentinhaber: VAT Holding AG, 9469 Haag (CH)
(72) Erfinder: Geiser, Friedrich, 6714 Nüziders (AT)
(74) Vertreter: Harmann, Bernd-Günther

(56) Entgegenhaltungen:
- WO-A2-00/45422
- DE-A1- 4 302 666
- DE-C1- 3 541 192
- JP-A- 6 273 766
- US-A- 5 275 303
- US-A1- 2005 274 923

## Beschreibung

Die Erfindung betrifft ein Klappen-Transferventil für den Transfer von Halbleiterelementen oder Substraten in eine gasdicht isolierbare Halbleiter- oder Substratbearbeitungs-Prozesskammer nach dem Oberbegriff des Anspruchs 1.

Ein derartiges Klappen-Transferventil ist aus der US 5,275,303 A (Szalai) bekannt.

Insbesondere im Bereich der IC- und Halbleiterfertigung, die in einer geschützten Atmosphäre möglichst ohne das Vorhandensein verunreinigender Partikel stattfinden muss, kommen diverse Vakuumventile zum Einsatz. Beispielsweise durchlaufen in einer Fertigungsanlage für Halbleiter-Wafer oder Flüssigkristall-Substrate die hochsensiblen Halbleiter-oder Flüssigkristall-Elemente sequentiell mehrere Prozesskammern, in denen die innerhalb der Prozesskammer befindlichen Halbleiterelemente mittels jeweils einer Bearbeitungsvorrichtung bearbeitet werden. Sowohl während des Bearbeitungsprozesses innerhalb der Prozesskammer, als auch während des Transfers von Prozesskammer zu Prozesskammer müssen sich die hochsensiblen Halbleiterelemente stets in geschützter Atmosphäre - insbesondere in luftleerer und partikelfreier Umgebung bzw. einer Schutzgasatmosphäre - befinden.

Die Prozesskammern sind beispielsweise über Transferkanäle miteinander verbunden. Diese Prozesskammern können mittels Vakuumtransferventilen zum Transfer der Teile von der einen zur nächsten Prozesskammer geöffnet und im Anschluss zur Durchführung des jeweiligen Fertigungsschritts gasdicht verschlossen werden. Ausserdem werden bewegliche Transferkammern verwendet, die an den Prozesskammern andocken und die Halbleiterelemente in Schutzatmosphäre zwischen den Prozesskammern transportieren können.

Aus dem Stand der Technik, beispielsweise der US 5,076,205 oder der US 5,292,393, sind Mehrkammersysteme zur Herstellung von Halbleiterelementen - insbesondere Halbleiter-Wafern - bekannt, bei welchen mehrere Prozesskammern sternförmig um eine mittige Transferkammer angeordnet sind. Die mittige Transferkammer ist über einen Tunnel mit einer zweiten Transferkammer, um welche weitere Prozesskammern sternförmig angeordnet sind, verbunden, so dass mittels einer Vielzahl derartiger Bearbeitungsinseln ein grosses zusammenhängendes Halbleiterfertigungssystem herstellbar ist. Die Halbleiterelemente werden mittels eines in der Transferkammer angeordneten Handhabungssystems von einer Prozesskammer über die Transferkammer in die nächste Prozesskammer transportiert.

Aus dem Stand der Technik sind ausserdem Vakuumkammersysteme bekannt, deren Prozesskammern entlang einer Linie angeordnet sind und vakuumdicht verschliessbare Öffnungen, die in eine gemeinsame Richtung weisen, besitzen. Eine parallel zu der Prozesskammerlinie linear verfahrbare Transferkammer ist an den einzelnen Prozesskammern andockbar und dient zum Transport der Bauteile von einer Prozesskammer zur nächsten Prozesskammer. Die evakuierte Transferkammer wird hierzu mit ihrer Transferkammeröffnung an eine Prozesskammeröffnung vakuumdicht angedockt. Ein derartiges System wird beispielsweise allgemein in der US-2007-0186851-A1 (Geiser) beschrieben.

Ausserdem ist es möglich, die Prozesskammern sequentiell in einer Aneinanderkettung von Prozesskammern anzuordnen, wobei zwischen den benachbarten Prozesskammern eine Verbindungsöffnung vorgesehen ist, welche mittels eines Transferventils gasdicht verschliessbar ist. Jede Prozesskammer weist in diesem Fall mindestens zwei Öffnungen auf, wobei die Ausgangsöffnung einer Prozesskammer jeweils die Eingangsöffnung einer in der Prozesskammerkette folgenden Prozesskammer ist. Zwischen jeweils zwei Prozesskammern und am Anfang und Ende der Prozesskammerkette befindet sich jeweils ein Transferventil, das jeweils zwei gasdicht voneinander trennbare Ventilöffnungen in seinem Ventilgehäuse aufweist.

Die beschriebenen Vakuumkammersysteme werden für unterschiedliche Bereiche der Halbleiter- und Substratfertigung eingesetzt und haben sich für die Herstellung und Bearbeitung von kleinen bis mittelgrossen Halbleiter- und Substratbauteilen bewährt. Neue technische Gebiete erfordern jedoch immer grössere einstückige Halbleiterbauteile und Substrate, die die Schaffung neuer Fertigungssysteme erfordern. Beispiele hierfür sind Solarpaneele oder Bildschirmpaneel, insbesondere Plasma- und LCD-Paneele, mit einer Breite von über einem Meter. Zur Bearbeitung derart grosser Halbleiterbauteile, Flüssigkristallsubstrate oder anderer Substrate sind entsprechend gross dimensionierte Prozesskammern und Tränsferventile erforderlich.

Unter einem Substrat ist allgemein im Sinne der Materialwissenschaft ein zu behandelndes Material zu verstehen, wobei insbesondere die Oberfläche des Substrats veredelt oder beschichtet wird. Es kann sich hierbei um einen Wafer aus dem Bereich der Halbleitertechnik, ein Basismaterial einer Leiterplatte oder ein sonstiges insbesondere plattenartiges oder bandartiges Material handeln, das mittels eines Beschichtungs-, Veredelungs- oder Behandlungsverfahren, das im Vakuum oder in Prozessgasumgebung stattfinden muss, entsprechend bearbeitet wird. Unter einem Substrat ist auch eine zu beschichtende Glasplatte, beispielsweise für einen Flachbildschirm oder ein Solarpaneel mit einer Dicke von unter 0,5 bis über 5 Millimeter, oder eine Edelstahlfolie oder ein Edelstahlband mit einer Dicke von unter 0,05 bis über 0,2 Millimeter zu verstehen.

Derartige Transferventile zum Öffnen und Schliessen von Prozesskammern zeichnen sich abhängig vom jeweiligen Prozess somit durch eine ausserordentlich grosse Dimensionierung, eine grosse Dichtungslänge und einen sehr grossen Öffnungsquerschnitt, zum Teil mit einer Breite von über 1000 Millimeter, aus. Die Öffnungsquerschnitte sind insbesondere langgestreckt und schlitzartig, wobei die Breite wesentlich grösser ist als die Höhe der Öffnung. Diese Ventile werden aufgrund des beschriebenen Anwendungsgebiets und der damit verbundenen Dimensionierung als Transferventile, aufgrund ihres rechteckigen Öffnungsquerschnitts auch als Rechteckventil und abhängig von ihrer Funktionsweise auch als Schieberventil, Rechteckschieber, Transferschieberventil, Klappenventil, Klappen-Transferventil oder Drehschleuse bezeichnet.

In der US 6,416,037 (Geiser) oder der US 6,056,266 (Blecha) werden klein dimensionierte Transferventile in Form von Vakuumschieberventilen oder Schieberventilen, auch Ventilschieber oder Rechteckschieber genannt, beschreiben. Das Schliessen und Öffnen erfolgt im Stand der Technik meist in zwei Schritten. In einem ersten Schritt wird ein Ventilverschluss, insbesondere ein Verschlussteller linear über eine Öffnung im Wesentlichen parallel zum Ventilsitz verschoben, ohne dass hierbei eine Berührung zwischen dem Ventilverschluss und dem Ventilsitz des Ventilgehäuses stattfindet. In einem zweiten Schritt wird der Ventilverschluss mit dessen Verschlussseite auf den Ventilsitz des Ventilgehäuses gedrückt, so dass die Öffnung gasdicht verschlossen wird. Die Abdichtung kann z.B. entweder über einen auf der Verschlussseite des Ventilverschlusses angeordneten Dichtungsring, der auf den die Öffnung umlaufenden Ventilsitz gepresst wird, erfolgen, oder über einen Dichtungsring auf dem Ventilsitz, gegen den die Verschlussseite des Ventilverschlusses gedrückt wird.

Ausserdem sind kleinere Schieberventile bekannt, bei welchen der Schliess- und Dichtvorgang über eine einzige lineare Bewegung erfolgt. Ein solches Ventil ist beispielsweise das unter der Produktbezeichnung "MONOVAT Reihe 02 und 03" bekannte und als Rechteckinsertventil ausgestaltete Transferventil der Firma VAT Vakuumventile AG in Haag, Schweiz. Der Aufbau und die Funktionsweise eines solchen Ventils werden beispielsweise in der US 4,809,950 (Geiser) und der US 4,881,717 (Geiser) beschrieben.

Derartige Antriebstechniken haben sind im Stand der Technik bewährt, sie eignen sich jedoch nur bedingt für sehr grosse Öffnungsquerschnitte, insbesondere langgestreckte, schlitzartige Öffnungsquerschnitte.

Aufgrund der sich durch den grossen Öffnungsquerschnitt ergebenden grossen Dichtungslängen sind die Anforderungen an die Dichtungen, die Führung des Ventilverschlusses sowie den Antrieb sehr hoch.

Unterschiedliche Dichtvorrichtungen sind aus dem Stand der Technik bekannt, beispielsweise aus der US 6,629,682 B2 (Duelli). Ein geeignetes Material für Dichtungsringe ist beispielsweise das unter dem Handelsnamen Viton® bekannte elastische Dichtungsmaterial.

Bei derart grossen Dichtungslängen und Öffnungsquerschnitten besteht eine besondere Herausforderung darin, über die gesamte Dichtungslänge selbst bei sehr grossen Druckdifferenzen die Dichtigkeit zu gewährleisten. Das Dichtungsverhalten der zum Einsatz kommenden Dichtungen ist meist auf einen sehr geringen Bereich begrenzt. Überschreitet der Abstand zwischen dem Ventilverschluss und dem Ventilsitz einen bestimmten Grenzwert, ist die Anpresskraft der Dichtung auf den Ventilsitz zu gering und die Dichtigkeit ist nicht mehr gewährleistet. Ist hingegen der Abstand zwischen dem Ventilverschluss und dem Ventilsitz zu gering und somit die Anpresskraft der Dichtung auf den Ventilsitz zu gross, unterliegt die Dichtung einem erheblichen Verschleiss und wird unter Umständen zerstört. Aus diesem Grunde ist im geschlossenen Zustand des Ventils selbst bei grossen Druckdifferenzen stets ein gewisser Anpressdruck der Dichtung auf den Ventilsitz über die gesamte Länge der Dichtung einzuhalten. Dieser gewisse Anpressdruck ist auf einen relativ kleinen Bereich begrenzt.

Vor allem bei gross dimensionierten Ventilen, insbesondere mit einem ausgeprägten asymmetrischen Querschnitt, beispielsweise einer langgestreckten, schlitzartigen Öffnung, ist die Einhaltung eines konstanten Anpressdrucks bei grösseren Druckdifferenzen problematisch. Zur Einhaltung eines konstanten Anpressdrucks sehen bestimmte Transferventile eine besonders robuste Dimensionierung des Ventilverschlusses und dessen Antriebs sowie dessen Lagerung vor, so dass der Ventilverschluss selbst bei hohen Kräften, die aufgrund der Druckdifferenz auf den Ventilverschluss wirken, seine Sollstellung behält und nicht ungewollt seine Position verändert. Eine möglichst stabile und unelastische Ausbildung des Ventilverschlusses und dessen Antriebs- und Lagerungskomponenten erscheint zunächst nahe liegend zu sein. Ein weiteres Problem besteht jedoch nicht nur im allfällig elastischen Verhalten des Ventilverschlusses und dessen Peripherie. Im Falle gross dimensionierter Prozesskammern führen die Druckdifferenzen zwischen dem Kammerinneren und der Umgehung oder zwischen zwei Kammern zu einer Verformung der gesamten Kammerwand. Das an der Kammerwand angeordnete und mit dieser gekoppelte Transferventil unterliegt ebenfalls dieser Verformung der Kammerwand. Da sich der mit der Kammerwand gekoppelte Ventilsitz entsprechend der Wölbung der Kammerwand verformt, ist bei einem unverformten Ventilverschluss kein konstanter Anpressdruck der Dichtung entlang der Dichtungslänge gewährleistet.

Die US 5,275,303 A (Szalai) beschreibt einen Ventilverschlussmechanismus für eine Halbleitertransfervorrichtung. Der gehäuselose Ventilverschlussmechanismus umfasst ein Verschlussglied, das mittels eines Schwenkmechanismus zwischen einer offenen Stellung und einer geschlossenen Stellung schwenkbar ist. Der Schwenkmechanismus weist mindestens zwei Arme auf, von denen einer mit dem Verschlussmechanismus und ein anderer mit einem Pneumatikzylinder verbunden ist und die zueinander schwenkbar sind, so dass ein Schwenken der Arme zu einer Veränderung des Schwenkwinkels und somit zu einem Verstellen des Verschlussglieds zwischen der offenen und geschlossenen Stellung führt. Im an einer Öffnung einer Wand einer Kammer angeordneten Zustand des Ventilverschlussmechanismus drückt das Verschlussglied in der Geschlossenstellung auf die Öffnung und verschliesst somit diese Öffnung, wobei die Schwenkachse des Verschlussgliedes von der Schliessebene der Öffnung beabstandet ist.

Aus der DE 35 41 192 C1 ist ein Klappenventil bekannt, bestehend aus einem Gehäuse, in dem diametral gegenüberliegende Durchflussöffnungen angeordnet sind, von denen eine durch eine Ventilklappe verschliessbar ist, Die Ventilklappe ist um eine quer zur Achse der Durchflussöffnung ausserhalb derselben liegende Achse um 90° aus der Schliessin die Öffnungsstellung und umgekehrt schwenkbar. Ein Doppelhebel greift an der Ventilklappe an. Dieser besteht aus einem ersten Hebel, der am einen Ende an der Ventilklappe und am anderen Ende am freien Ende eines zweiten Hebels angelenkt ist, der an seinem anderen Ende an einer ausserhalb des Durchströmquerschnitts ortsfest liegenden Schwenkachse starr angebracht ist. Der Doppelhebel ist derart angeordnet und ausgebildet ist, dass seine Hebel in der Schliessstellung der Ventilklappe fluchten.

In der EP 0 554 522 A2 wird eine Drehschleuse zum Ein-und/oder Ausbringen eines Substrats von der einen in eine benachbarte Behandlungskammer oder aus dem atmosphärischen Raum in eine Kammer geringeren Drucks, insbesondere Schlitzschleuse für eine Durchlauf-Vakuumbeschichtungsanlage mit einer klappenartigen, in ortsfesten Lagern gehaltenen Ventilplatte und zwei mit dieser in Wirkverbindung stehenden Schliessmotoren beschrieben. Die Ventilplatte ist unter Zwischenschaltung zweier federnder Stäbe an einem Ventilbalken angelenkt, der seinerseits zwei einander diametral gegenüberliegende Lagerzapfen aufweist, die drehfest mit den Wellen der Motore gekuppelt sind, wobei die Wellen der Motore durch die Wand der Kammer druckfest hindurchgeführt sind. Mittels dieser Anordnung soll gewährleistet sein, dass über die ganze Länge der Ventilplatte eine gleichmässige Schliezskraft bzw. Anpresskraft erzeugbar ist. Im Wartungs- und Reparaturfall sollen die Druckstufe und die Antriebseinheit problemlos auswechselbar sein, während die vergleichsweise sperrige und schwere Ventileinheit komplett montiert im Rezipienten verbleibt. Ein Nachteil der beschriebenen Drehschleuse besteht darin, dass im Falle einer Verformung der Wand der Kammer die Elastizität der Vorrichtung nicht ausreicht, um eine konstante Anpresskraft zu gewährleisten. Ein Austausch der sperrigen und schweren Ventileinheit ist mit einem grossen Aufwand verbunden.

Die Notwendigkeit einer möglichst konstanten Anpresskraft entlang der Dichtungslänge der Dichtung eines Transferventils, selbst bei unvermeidbaren elastischen Verformungen des Ventilsitzes und des Ventilverschlusses, wie sie vor allem bei langgestreckten, insbesondere schlitzartigen Öffnungsquerschnitten auftreten, stellt ein bisher nicht hinreichend gelöstes Problem im Stand der Technik dar.

Bei Betätigung des Ventils und gasdichten Schliessen und wieder Öffnen ist die zum Einsatz kommende Dichtung einer dynamischen Belastung ausgesetzt und unterliegt somit zwangsläufig einem gewissen mechanischen Verschleiss. Ein regelmässiges Austauschen dieser Dichtung oder des gesamten Dichtungsträgers, insbesondere des Ventilverschlusses, vor allem bei sehr hohen Anforderungen an die Dichtheit des Ventils und die Partikelfreiheit ist somit erforderlich. Manche Prozesse innerhalb der Prozesskammern werden in aggressiver Prozessgasatmosphäre durchgeführt. Teilweise bewirken gewisse Prozesse eine erhebliche Verunreinigung des Prozesskammerinneren, Derartige aggressive Gase greifen zum Teil auch den Ventilverschluss des Transferventils und dessen Dichtung an. Eine regelmässige Wartung des Vakuum-Transferventils, insbesondere ein Austausch der Dichtungen oder des gesamten Verschlusses, ist zur Gewährleistung der Gasdichtheit und der Reinhaltung der Prozessatmosphäre teilweise unvermeidlich.

Transferventile sind bei zahlreichen Anwendungen in einem schmalen Zwischenraum zwischen zwei Prozesskammern angeordnet. Für die Wartung des Transferventils insbesondere für den Austausch der Dichtung oder des Verschlusstellers, erfordern die aus dem Stand der Technik bekannten Transferventile mit einem langgestreckten, insbesondere schlitzartigen öffnungsquerschnitt, dass das gesamte Ventil von den Prozesskammern entkoppelt werden muss. Hierzu muss der Abstand der Prozesskammern temporär vergrössert worden, um einen Zugang zum Ventil zu ermöglichen. Ein einfaches Austauschen des Ventilverschlusses im montierten Zustand des Ventils ist nicht möglich.

Der vorliegenden Erfindung liegt daher die Aufgabe zugrunde, ein Transferventil, das eine langgestreckte, insbesondere schlitzartige Öffnung aufweist, so auszubilden, dass im Wartungs- und Reparaturfall der Ventilverschluss ohne zwangsläufige Demontage des Transferventils von den Prozesskammern auswechselbar sind.

Diese Aufgabe wird durch die Verwirklichung der kennzeichnenden Merkmale des unabhängigen Patentanspruchs gelöst. Merkmale, die die Erfindung in alternativer oder vorteilhafter Weise weiterbilden, sind den abhängigen Patentansprüchen zu entnehmen.

Ein erster Aspekt der Erfindung betrifft ein servicefreundliches Klappen-Transferventil für den Transfer von Halbleiterelementen oder Substraten in eine gasdicht isolierbare Halbleiter- oder Substratbearbeitungs-Prozesskammer. In anderen Worten handelt es sich um ein Transferventil mit einem Klappenantrieb zum Öffnen und gasdichten Schliessen einer für den Transfer von Halbleiterelementen oder Substraten ausgebildeten Transferöffnung einer Halbleiter- oder Substratbearbeitungs-Prozesskammer.

Das Klappen-Transferventil hat eine langgestreckte, insbesondere schlitzartige ersten Öffnung, die sich entlang einer ersten Längsachse erstreckt und die von einer ersten Dichtfläche rahmenförmig umschlossen ist. Unter langgestreckt und schlitzartig ist zu verstehen, dass die Breite der insbesondere rechteckigen ersten Öffnung entlang ihrer ersten Längsachse mindestens das Dreifach, insbesondere das Vierfache, Fünffache, Sechsfache, Achtfache, Zehfache oder Zwölffache der Höhe der ersten Öffnung senkrecht zur ersten Längsachse beträgt. Die Breite der ersten Öffnung beträgt beispielsweise über 500 Millimeter, insbesondere über 800 Millimeter, im Speziellen über 1000 Millimeter. Die erste Längsachse erstreckt sich entlang der Breite der Öffnung und verläuft senkrecht zu der Öffnungsachse, welche die Normale zum Öffnungsquerschnitt bildet.

Um die erste Öffnung gasdicht verschliessen zu können, ist ein langgestreckter Ventilverschlussbalken vorgesehen. Der langgestreckte Ventilverschlussbalken hat vorzugsweise einen rechteckigen Querschnitt, der mit dem vorzugsweise rechteckigen Querschnitt der ersten Öffnung korrespondiert und die erste Öffnung ringsum überlappt, so dass mittels des Ventilverschlussbalkens die erste Öffnung vollständig überdeckbar ist. Die genannten Breiten- und Höhenverhältnisse der ersten Öffnung gelten somit auch für den Ventilverschlussbalken. Der Ventilverschlussbalken erstreckt sich entlang einer zur ersten Längsachse im Wesentlichen parallelen zweiten Längsachse. In anderen Worten erstreckt sich die zweite Längsachse entlang der Breite des Ventilverschlussbalkens und verläuft parallel zur ersten Längsachse. Unter einem Ventilverschlussbalken ist allgemein ein langgestreckter Ventilverschluss zu verstehen, insbesondere ein breiter Ventilteller. Der Ventilverschlussbalken besitzt eine Vorderseite und eine Rückseite. Mittels der Vorderseite kann die erste Öffnung verschlossen werden. Hierzu sind auf der Vorderseite eine Verschlussfläche zum Verschliessen der ersten Öffnung und eine mit der ersten Dichtfläche korrespondierende und mit ihr in gasdichten Kontakt bringbare zweite Dichtfläche vorgesehen. In anderen Worten kann durch im Wesentlichen senkrechtes Aufdrücken des Ventilverschlussbalkens mit dessen zweiten Dichtfläche ein gasdichter Kontakt mit der ersten Dichtfläche, welche rings um die erste Öffnung verläuft, hergestellt werden.

In einer möglichen Ausführungsform ist die erste Dichtfläche rings um die erste Öffnung ein insbesondere ebener Ventilsitz. Die zweite Dichtfläche wird von einer beispielsweise elastischen Dichtung gebildet, die auf der Vorderseite des Ventilverschlussbalkens auf dessen Verschlussfläche angeordnet ist. Die Dichtung kann jedoch auch von der ersten Dichtfläche gebildet werden.

Mittels einer Schwenklagerung ist der Ventilverschlussbalken um eine zur zweiten Längsachse des Ventilverschlussbalkens und somit auch zur ersten Längsachse der ersten Öffnung im Wesentlichen parallele Schwenkachse zwischen einer Geschlossenstellung und einer Offenstellung schwenkbar. In der Geschlossenstellung überdeckt der Ventilverschlussbalken mit seiner Verschlussfläche die erste Öffnung und verschliesst die erste Öffnung gasdicht, wobei die erste Dichtfläche und die zweite Dichtfläche in gasdichtem Kontakt zueinander stehen. In anderen Worten ist der Ventilverschlussbalken in der Geschlossenstellung auf die erste Öffnung geschwenkt und verschliesst diese.

In der Offenstellung ist der Ventilverschlussbalken von der ersten Öffnung weggeschwenkt. Der Ventilverschlussbalken gibt die erste Öffnung somit frei. Vorzugsweise ist der Ventilverschlussbalken in der Offenstellung vollständig aus der Projektion des Öffnungsquerschnitts geschwenkt, so dass ein ungehinderter Transfer von Substraten und Halbleiterelementen durch die erste Öffnung erfolgen kann. Der Schwenkwinkel des Ventilverschlussbalkens zwischen der Offenstellung und der Geschlossenstellung beträgt vorzugsweise etwa 90 Grad, insbesondere zwischen 60 und 105 Grad.

Unter einer Schwenklagerung ist allgemeine funktional eine Lagerung zu verstehen, welche ein Schwenken des Ventilverschlussbalkens um die Schwenkachse ermöglicht. Mittels welcher struktureller Merkmale eine derartige Schwenklagerung umsetzbar ist, wird von weiterführenden Aspekten der Erfindung umfasst.

Ausserdem besitzt das Klappen-Transferventil eine Welle, die um ihre sich längs der Welle zentrisch erstreckende Wellenachse drehbar gelagert ist. Die Wellenachse verläuft zur zweiten Längsachse des Ventilverschlussbalkens und somit auch zur ersten Längsachse der ersten Öffnung im Wesentlichen parallel. Diese Welle steht in derartiger Wirkverbindung zu dem Ventilverschlussbalken, dass ein Drehen der Welle um die Wellenachse ein Schwenken des Ventilverschlussbalkens um die Schwenkachse bewirkt. Die Art dieser Wirkverbindung wird ebenfalls von weiterführenden Aspekten der Erfindung umfasst und im Folgenden noch detaillierter beschrieben.

Mindestens ein Antrieb ist mit der Welle zum Drehen der Welle um die Wellenachse gekoppelt. Aufgrund der Wirkverbindung der Welle mit dem Ventilverschlussbalken wird durch das Verdrehen der Welle der Ventilverschlussbalkens zwischen der Offenstellung und der Geschlossenstellung verstellt. Bei dem Antrieb kann es sich beispielsweise um einen Drehantrieb, dessen erzeugte Drehbewegung direkt oder indirekt zu einer Drehbewegung der Welle führt, oder einen Linearantrieb, dessen Axialbewegung insbesondere mittels eines an der Welle direkt oder indirekt angeordneten Hebels in eine Drehbewegung der Welle umgewandelt wird, handeln.

Die vorangegangene Darstellung des Klappen-Transferventils bezieht sich auf beide Aspekte der Erfindung, die im Folgenden genauer gesondert erläutert werden.

Gemäss einem ersten Aspekt der Erfindung umfasst das Klappen-Transferventil ein gasdichtes Ventilgehäuse. In dem Ventilgehäuse ist auf einer ersten Öffnungsseite die erste Öffnung, die bereits oben genauer beschrieben wurde, ausgeformt.

In einer möglichen Ausführungsform liegt der ersten Öffnung eine zweite Öffnung im Ventilgehäuse gegenüber. Die Öffnungen verbinden jeweils das Innere des Ventilgehäuses mit dem Äusseren des Ventilgehäuses, wobei zumindest die erste Öffnung durch das Schliessen mittels des Ventilverschlussbalkens schliessbar und somit die diesbezügliche Verbindung des Ventilinneren mit dem Ventiläusseren trennbar ist. Die der äusseren ersten Öffnungsseite gegenüberliegende äussere Seite des Ventilgehäuses wird als die zweite Öffnungsseite des Ventilgehäuses bezeichnet. Unter gegenüberliegend ist nicht zwangsläufig eine exakte geometrische Gegenüberlage zu verstehen, sondern allgemein, dass die erste Öffnungsseite und die zweite Öffnungsseite in unterschiedliche Richtungen weisen. Es ist jedoch auch möglich, dass das Ventilgehäuse keine derartige zweite Öffnung aufweist.

Der Ventilverschlussbalken, die Schwenklagerung und die Welle sind im gasdichten Ventilgehäuse angeordnet. Das Ventilgehäuse weist auf einer langgestreckten Seitenwand einen mit dem restlichen Ventilgehäuse gasdicht gekoppelten, in eine Seitenrichtung parallel zu der ersten Öffnungsseite abnehmbaren Ventildeckel auf.

In anderen Worten besitzt das Ventilgehäuse auf einer Seite, die vorzugsweise im rechten Winkel zu der ersten Öffnungsseite und insbesondere der zweiten Öffnungsseite steht, eine Serviceöffnung. Diese Serviceöffnung erstrecht sich auf einer langgestreckten Seite des Ventilgehäuses, also im Wesentlichen parallel zu der ersten und der zweiten Längsachse sowie der Wellenachse. Die Serviceöffnung ist somit auf einer Seite angeordnet, die im an eine Prozesskammer montierten Zustand des Ventilgehäuses zugänglich ist. Selbst wenn das Ventilgehäuses im Zwischenraum zwischen zwei Prozesskammern angeordnet ist, wobei die beiden Öffnungsseiten jeweils an die Prozesskammern angrenzen und die beiden Öffnungen in die Prozesskammern führen, bleibt die langgestreckte Seitenwand des Ventilgehäuses zugänglich. Die Serviceöffnung ist mittels des genannten Ventildeckels gasdicht verschlossen. Der Ventildeckel ist beispielsweise mittels Schrauben am Ventilgehäuse zum gasdichten Verschluss der Serviceöffnung angeordnet und in die genannte Seitenrichtung, in welche die Serviceöffnung weist, abnehmbar.

Die Welle, die in derartiger Wirkverbindung zu dem Ventilverschlussbalken steht, dass ein Drehen der Welle um die Wellenachse ein Schwenken des Ventilverschlussbalkens um die Schwenkachse bewirkt, ist auf dem Ventildeckel drehbar gelagert. Die Schwenklagerung, die Welle und der Ventilverschlussbalken sind derart auf dem Ventildeckel angeordnet, dass durch Entkoppeln und Entfernen des Ventildeckels in die Seitenrichtung auch die Welle, die Schwenklagerung und der Ventilverschlussbalken vom Ventilgehäuse entkoppelbar sind. In anderen Worten ist der Ventilverschlussbalken auf dem Ventildeckel schwenkbar montiert, wobei sowohl die Schwenklagerung, mittels welcher der Ventilverschlussbalken um die Schwenkachse schwenkbar ist, als auch die Welle zum Bewirken des Schwenkens des Ventilverschlussbalkens mit dem Ventildeckel gekoppelt sind.

Durch Entfernen des Ventildeckels vom Ventilgehäuse wird somit auch der Ventilverschlussbalken vom restlichen Klappen-Transferventil entkoppelt. Es ist somit durch Abnehmen des Ventildeckels möglich, den Ventilverschlussbalken zu Warten, insbesondere dessen Dichtung auszutauschen oder den gesamten Ventilverschlussbalken gegen einen neuen zu ersetzen. Auch die besonders für Verunreinigungen anfällige Schwenklagerung kann als Bestandteil des Ventildeckels ohne grossen Aufwand an einem von den Prozesskammern entfernten Ort gewartet werden. Ein grosser Vorteil dieser Anordnung besteht nicht nur darin, dass nahezu sämtliche, einem erhöhten Verschleiss und einer Verunreinigung ausgesetzten Komponenten des Klappen-Transferventils durch Abnehmen des Ventildeckels an einen vom sensiblen Prozess entfernten Serviceort gebracht werden können, sondern auch in der leichten Austauschbarkeit aller dieser Komponenten durch Ersetzen des entkoppelten Servicedeckels gegen einen neuen Servicedeckel mit neuen Komponenten.

In einer Weiterbildung der Erfindung ist der Antrieb auf einem vom Ventildeckel entkoppelten Abschnitt des Ventilgehäuses angeordnet. Um den nicht auf dem Ventildeckel montierten Antrieb von der auf dem Ventildeckel gelagerten Welle entkoppeln zu können, ist zwischen der Welle und dem Antrieb eine in die Seitenrichtung lösbare Kupplung angeordnet. Diese Kupplung ist derart ausgebildet, dass die Welle vom Antrieb zum Abnehmen des Ventildeckels entkoppelbar ist. In anderen Worten bildet die Kupplung eine in die Seitenrichtung, in welche der Ventildeckel abnehmbar ist, lösbare Verbindung zwischen der Welle und dem Antrieb.

Die Kupplung wird beispielsweise von einem ersten Abschnitt der Welle und einem mit dem ersten Abschnitt in Formschluss gekoppelten zweiten Abschnitt einer Antriebswelle des Antriebs gebildet. Der Formschluss ist durch das Entfernen des Ventildeckels in die Seitenrichtung auflösbar, so dass die Welle vom Antrieb entkoppelbar ist. Die beiden Abschnitte können beispielsweise von in Eingriff stehenden Zahnrädern gebildet werden. In einer speziellen Ausführungsform verlaufen die Wellenachse und eine Antriebswellenachse der Antriebswelle parallel zueinander oder sind kollinear, liegen also aufeinander. Der erste Abschnitt der Welle wird beispielsweise von einem Ende der Welle gebildet, wobei das Ende der Welle eine erste Ausformung aufweist, die sich in einer Grundstellung der Welle zumindest teilweise senkrecht zur Wellenachse und in die Seitenrichtung erstreckt. Der zweite Abschnitt der Antriebswelle wird von einem Ende der Antriebswelle gebildet, wobei das Ende der Antriebswelle eine zweite Ausformung aufweist, die sich in der Grundstellung der Welle zumindest teilweise senkrecht zur Antriebswellenachse und in die Seitenrichtung erstreckt. Die zweite Ausformung korrespondiert mit der ersten Ausformung zur Herstellung des Formschlusses. Die Grundstellung der Welle ist beispielsweise diejenige Stellung der Welle, in welcher sich der Ventilverschlussbalken in der Offenstellung befindet. Insbesondere sind die zweite Ausformung als eine Nut am Ende der Antriebswelle und die erste Ausformung als ein Keil am Ende der Welle ausgebildet. Alternativ sind die erste Ausformung als eine Nut am Ende der Welle und die zweite Ausformung als ein Keil am Ende der Antriebswelle ausgebildet. Keil und Nut greifen im montierten Zustand des Ventildeckels formschlüssig ineinander, so dass ein Drehmoment vom Antrieb auf die Welle übertragen werden kann, und erstrecken sich beide in der Grundstellung der Welle in die Seitenrichtung, also insbesondere in Richtung senkrecht zur Ebene der Serviceöffnung. Die Antriebswelle ist in einer Ausführungsform der Erfindung gasdicht aus dem Ventilgehäuse herausgeführt, wobei der Antrieb aussen am Ventilgehäuse auf dem nicht mit dem Ventildeckel gekoppelten Abschnitt des Ventilgehäuses angeordnet ist.

Alternativ besteht erfindungsgemäss auch die Möglichkeit, dass der Antrieb mit dem Ventildeckel derart gekoppelt ist, dass er gemeinsam mit dem Ventildeckel vom Ventilgehäuse entkoppelbar ist. In anderen Worten ist der Antrieb auf dem Ventildeckel direkt oder indirekt montiert und treibt insbesondere direkt die Welle an. Ein Vorteil dieser Anordnung besteht darin, dass auch der Antrieb durch das Demontieren des Ventildeckels vom Ventilgehäuse entkoppelt werden kann und eine einfache Wartung, gegebenenfalls auch ein Austausch des Antriebs erfolgen kann. Ein Nachteil dieser Anordnung ist jedoch, dass der Ventildeckel eine relativ schwere Komponente umfasst, die bei zahlreichen Anwendungen einem wesentlich geringen Verschleiss unterliegt als insbesondere der Ventilverschlussbalken mit dessen Dichtung. Sofern jedoch eine regelmässige Wartung und gegebenenfalls ein regelmässiger Austausch des Antriebs zu erfolgen hat, ist diese Ausführungsform von besonderem Vorteil.

Gemäss dem genannten ersten Aspekt der Erfindung bestehen diverse Möglichkeiten, wie die Schwenklagerung ausgebildet ist und auf welche Weise die Wirkverbindung zwischen der Welle und dem Ventilverschlussbalken besteht. In einer möglichen, einfachen Ausführungsform ist der Ventilverschlussbalken unmittelbar an der Welle angeordnet und wird von der Welle geschwenkt. Beispielsweise ist der Ventilverschlussbalken an mindestens einem mit der Welle drehfest verbundenen Arm angeordnet. Die Schwenkachse und die Wellenachse sind somit kollinear und bilden eine gemeinsame Achse. Die funktionale Schwenklagerung des Ventilverschlussbalkens wird von der verdrehbaren Welle und insbesondere dem mindestens einem Arm gebildet. Eine derartige konventionelle Schwenklagerung ist beispielsweise aus der EP 0 554 522 bekannt.

Ein Aspekt des Klappen-Transferventils umfasst eine vorteilhafte Schwenklagerung des Ventilverschlussbalkens. Dieser Aspekt des Klappen-Transferventils kann mit dem ersten Aspekt der Erfindung, also mit dem servicefreundlichen Ventildeckel, kombiniert oder vom ersten Aspekt unabhängig ausgeführt werden.

Gemäss diesem Aspekt des Klappen-Transferventils wird die Schwenklagerung von mindestens drei, insbesondere mindestens fünf, im Speziellen mindestens acht Lagerelementen gebildet. Diese Lagerelemente sind entlang der Wellenachse und entlang der Schwenkachse im Ventilgehäuse voneinander beabstandet verteilt. Vorzugsweise sind die Lagerelemente gleichmässig verteilt und haben zueinander einen im Wesentlichen gleichen Abstand.

Der Ventilverschlussbalken ist an den Lagerelementen um die gemeinsame Schwenkachse schwenkbar gelagert, wobei die Schwenkachse seitlich zur ersten Öffnung, insbesondere nahe der Ebene der ersten Dichtfläche und im Speziellen im Wesentlichen in der Ebene der ersten Dichtfläche verläuft. In anderen Worten ist der Ventilverschlussbalken mit den Lagerelementen schwenkbar verbunden, wobei eine Schwenklagerung auf den Lagerelementen den Ventilverschlussbalken um die Schwenkachse bewegbar macht.
Die Schwenkachse verläuft auf der Seite der ersten Öffnungsseite, in einer speziellen Ausführungsform nahe oder auf der Schnittgeraden der Ebenen der ersten und der zweiten Dichtfläche.

Die Welle ist in zumindest einem Teil der Lagerelemente gelagert. Vorzugsweise weisen alle Lagerelemente ein Radiallager auf, in welchem die Welle gelagert ist, wobei die Welle insbesondere durch die Lagerelemente hindurchgeführt ist. Die Wellenachse ist von der Schwenkachse in Richtung senkrecht zur Ebene der ersten Dichtfläche beabstandet. In anderen Worten liegen die Schwenkachse und die Wellenachse nicht aufeinander, sondern weisen einen Abstand in Richtung der Öffnungsachse der ersten Öffnung, also einen Abstand in Richtung der Normalen der Ebene der ersten Dichtfläche auf. Insbesondere verlaufen die Schwenkachse auf derjenigen Seite des Ventilgehäuses, auf welcher die erste Öffnung angeordnet ist, und die Wellenachse auf der gegenüberliegenden Seite des Ventilgehäuses, auf welcher insbesondere die zweite Öffnung angeordnet ist.

Den Lagerelementen ist jeweils mindestens ein an der Welle drehfest angeordneter erster Arm zugeordnet. Die ersten Arme erstrecken sich insbesondere parallel zueinander und senkrecht zur Wellenachse. Die ersten Arme stehen jeweils an ihrem freien Ende direkt oder indirekt mit einer Rückseite des Ventilverschlussbalkens derart in Eingriff, dass durch Drehen der Welle und somit durch Schwenken der ersten Arm um die Wellenachse eine Kraft auf die Rückseite des Ventilverschlussbalkens zum Schwenken des Ventilverschlussbalkens um die Schwenkachse zwischen der Offenstellung und der Geschlossenstellung aufbringbar ist. In anderen Worten steht die Welle über die ersten Arm mit dem Ventilverschlussbalken zum Schwenken des Ventilverschlussbalkens um die Schwenkachse in Wirkverbindung, indem mittels der ersten Arme auf die Rückseite des Ventilverschlussbalkens eine Schliesskraft ausgeübt wird.

Durch diese Anordnung, welche eine Trennung zwischen der Schwenkachse des Ventilverschlussbalkens von der Wellenachse sowie eine Lagerung sowohl des Ventilverschlussbalkens als auch der Welle vorsieht, werden wesentliche Vorteile in Hinblick auf die Belastbarkeit und Dichtigkeit des Ventils erzielt. Da die Schliesskraft auf die Rückseite des Ventilverschlussbalkens eingebracht wird und sich die Arme auf die von der Schwenkachse beabstandete Welle abstützen, ist es möglich, wesentlich höhere Schliesskräfte entlang dem Ventilverschlussbalken einzubringen. Da sich sowohl die Welle, als auch der Ventilverschlussbalken auf den entlang der Längsachse verteilten, beabstandeten Lagerelemente abstützen, wird die Anpresskraft des Ventilverschlussbalkens diskret entlang der ersten Längsachse verteilt, wobei die Lagerelemente voneinander entkoppelt sind. Wird beispielsweise auf ein mittig angeordnetes Lagerelement aufgrund einer Durchbiegung des Ventilverschlussbalkens eine grössere Kraft ausgeübt als auf ein seitliches Lagerelement, so kann das mittige Lagerelement dieser Druckkraft elastisch nachgeben, ohne dass hiervon die seitlichen Lagerelemente betroffen sind. Da die Welle aufgrund der Hebelwirkung der ersten Arme auf die Rückseite des Ventilverschlussbalkens im Wesentlichen keiner Torsion, sondern lediglich, abhängig von der Lage der ersten Armen zu den Lagerpunkten in den Lagerelementen, einer geringen Durchbiegung ausgesetzt wird, koppelt die Welle die Lagerelemente im Falle einer Belastung kaum miteinander.

In einer Weiterbildung des Klappen-Transferventils ist den ersten Armen jeweils ein zweiter Arm zugeordnet, der auf der Rückseite des Ventilverschlussbalkens um eine zweite Armachse, die parallel zur Schwenkachse verläuft, schwenkbar gelagert ist. Jeweils der erste Arm und der zweite Arm sind an ihren freien Enden um eine zur zweiten Armachse im Wesentlichen parallele erste Armachse gelenkig miteinander verbunden. Die Welle, die ersten Arme und die zweiten Arme bilden somit einen Hebelantrieb, insbesondere einen Kniehebel- oder Spannhebelmechanismus. Vorzugsweise sind die Längen der ersten Arme und der zweiten Arme und die Abstände der gemeinsamen Wellenachse, der gemeinsamen ersten Armachse und der gemeinsamen zweiten Armachse derart, dass die Wellenachse, die erste Armachse und die zweite Armachse in der Geschlossenstellung im Wesentlichen in einer gemeinsamen Ebene liegen und sich die ersten Arme und die zweiten Arme im Wesentlichen in Totpunktausrichtung befinden. Aufgrund dieser Totpunktausrichtung wird in der Geschlossenstellung kein Drehmoment im Falle einer Druckdifferenz am Ventilverschlussbalken ausgeübt, so dass es zu keiner Torsion der Welle kommt. Sofern die ersten Arme nahe der Lagerelemente, also im Bereich der Lagerelemente an der Welle angeordnet sind, kann auch eine Durchbiegung der Welle weitgehend vermieden werden, so dass das Klappen-Transferventil selbst bei sehr hohen Druckdifferenzen seine geforderte Dichtigkeit behält. Alternativ besteht jedoch auch die Möglichkeit, die ersten Arme jeweils in der Mitte zweier Lagerelemente auf der Welle anzuordnen, beispielsweise um bewusst eine gewisse Nachgiebigkeit aufgrund der Wellendurchbiegung zu ermöglichen.

Des Klappen-Transferventil sieht in einer Weiterbildung vor, dass der Ventilverschlussbalken, die Schwenklagerung und die Welle in einem Ventilgehäuse angeordnet sind. Die erste Öffnung ist auf einer ersten Öffnungsseite des Ventilgehäuses angeordnet. Eine der ersten Öffnung gegenüberliegende zweite Öffnung ist auf einer der ersten Öffnungsseite gegenüberliegenden zweiten Öffnungsseite des Ventilgehäuses angeordnet. Die Lagerelemente erstrecken sich auf einer langgestreckten Seitenwand des Ventilgehäuses, die sich im Wesentlichen senkrecht zwischen den beiden Öffnungsseiten erstreckt. Insbesondere ist es möglich, dass die Lagerelemente auf einem abnehmbaren Ventildeckel, insbesondere auf dem abnehmbaren Ventildeckel des ersten Aspekts der Erfindung, befestigt sind.

In einer weiteren Fortbildung des Klappen-Transferventils erstrecken sich die Lagerelemente jeweils zwischen der ersten Öffnungsseite und der zweiten Öffnungsseite im Ventilgehäuse. Insbesondere sind die Lagerelemente alle zueinander parallel ausgerichtet. Die Lagerelemente lassen sich in zwei Hälften einteilen, nämlich in eine zur ersten Öffnungsseite weisenden Hälfte und die von der ersten Öffnungsseite weg weisende Hälfte, also in eine zur zweiten Öffnungsseite weisenden Hälfte. Die Lagerelemente sind auf ihrer zur ersten Öffnungsseite weisenden Hälfte am Ventilgehäuse fixiert, wohingegen sie auf der zur zweiten Öffnungsseite weisenden Hälfte senkrecht zur Seitenwand und in Richtung weg von der Seitenwand zumindest teilweise unfixiert und beweglich sind. In anderen Worten sind die Lagerelemente lediglich mit ihrer zur ersten Öffnungsseite weisenden Hälfte am Ventilgehäuse in senkrechter Richtung fixiert, und zwar vorzugsweise auf der zur ersten Öffnungsseite weisenden Hälfte der Seitenwand und/oder auf der ersten Öffnungsseite des Ventilgehäuses. Die von der ersten Öffnung weg weisende Hälfte der Lagerelemente ist hingegen unfixiert und in Richtung weg von der Seitenwand zumindest teilweise beweglich. Die Schwenkachse verläuft durch die zur ersten Öffnungsseite weisenden Hälfte der Lagerelemente. Die Wellenachse verläuft durch die zur zweiten Öffnungsseite weisenden Hälfte der Lagerelemente. Vorzugsweise liegen die Lagerelemente mit ihren zur ersten Öffnungsseite weisenden Hälften auf der Seitenwand auf und sind in senkrechter Richtung mit der Seitenwand fixiert, wohingegen die Lagerelemente mit ihren zur zweiten Öffnungsseite weisenden Hälfte auf der Seitenwand aufliegen und in senkrechter Richtung weg von der Seitenwand unfixiert sind.

Durch diese Anordnung sind die Lagerelemente mit demjenigen Abschnitt des Ventilgehäuses gekoppelt, welcher an die erste Öffnung und die erste Öffnungsseite, mit welcher das Klappen-Transferventil an der Prozesskammer angeordnet ist, angrenzt. Kommt es aufgrund einer grossen Druckdifferenz zu einer Wölbung der gesamten auf der ersten Öffnungsseite liegenden Wand des Ventilgehäuses in Richtung des Ventilinneren, stützt der Ventilverschlussbalken die gesamte Wand mit ihrer ersten Dichtungsfläche rings um die erste Öffnung über die Arme, die Welle und die Lagerelemente entlang der gesamten Breite des Ventilverschlussbalkens ab. Das Abstützen erfolgt hierbei vor allem über die zur zweiten Öffnungsseite weisenden Hälfte der Lagerelemente in Richtung senkrecht auf die Seitenwand, auf welcher die zur zweiten Öffnungsseite weisende Hälfte des Lagerelements aufliegt.

Im Falle einer entgegen gesetzten Druckdifferenz und einer Wölbung der gesamten auf der ersten Öffnungsseite liegenden Wand des Ventilgehäuses in Richtung des Ventiläusseren würde es bei einem feststehenden Ventilverschlussbalken zu einem Abheben der ersten Dichtungsfläche von der zweiten Dichtungsfläche kommen. Da die Lagerelemente aber mit demjenigen Abschnitt des Ventilgehäuses, welcher der Wölbung unterliegt, nämlich mit der zur ersten Öffnungsseite weisenden Hälfte der Seitenwand und/oder der ersten Öffnungsseite des Ventilgehäuses, nicht jedoch mit der anderen Hälfte des Ventilgehäuses, wirkt sich die Verformung der die erste Öffnung umgebenden Wand auch auf die Lagerelemente aus. Da die Lagerelemente auf der von der ersten Öffnung weg weisenden Seite unfixiert sind, können die Lagerelemente der Gehäuseverbiegung nachgeben und kippen in Richtung zur ersten Öffnung. Die Lagerelemente geben also der Gehäuseverformung nach, so dass der Abstand zwischen der zweiten Dichtfläche des Ventilverschlussbalkens und der ersten Dichtfläche rings um die erste Öffnung entlang der ersten Langsachse konstant bleibt. Ein Abheben der Dichtflächen kann somit vermieden werden. Da die einzelnen Lagerelemente voneinander entkoppelt sind, kann eine entlang der ersten Längsachse der ersten Öffnung ungleichmässige Wölbung der Wand gleichmässig ausgeglichen werden. Das Klappen-Transferventils kann somit selbst bei einem sehr grossen Öffnungsquerschnitt und einer grossen Längserstreckung hohen Druckdifferenzen mit der geforderten Dichtigkeit standhalten.

Ein erfindungsgemässes Klappen-Transferventil wird nachfolgend anhand von in den Zeichnungen schematisch dargestellten konkreten Ausführungsbeispielen rein beispielhaft näher beschrieben.

Im Einzelnen zeigen
- Fig. 1: eine Schrägansicht auf ein erfindungsgemässes Klappen-Transferventil mit einem entkoppelten Ventildeckel;
- Fig. 2: eine Schrägansicht auf den entkoppelten Ventildeckel;
- Fig. 3: eine geschnittene Schrägansicht auf das Klappen- Transferventil mit dem montiertem Ventildeckel in einer Zwischenstellung des Ventilverschlussbalkens;
- Fig. 4: eine seitliche Querschnittsansicht auf das Klappen-Transferventil mit dem montiertem Ventildeckel in einer Offenstellung des Ventilverschlussbalkens;
- Fig. 5: eine Seitenansicht auf den entkoppelten Ventildeckel;
- Fig. 6: eine Detail-Schrägansicht auf eine erste Ausformung am Ende der Welle in Form eines Keils als Element einer Kupplung;
- Fig. 7: eine Detail-Schrägansicht auf eine zweite Ausformung am Ende der Antriebswelle in Form einer Nut als Element der Kupplung;
- Fig. 8a: eine seitliche Querschnittsansicht auf das Klappen-Transferventil mit dem montiertem Ventildeckel in einer Zwischenstellung des Ventilverschlussbalkens;
- Fig. 8b: eine seitliche Querschnittsansicht auf das Klappen-Transferventil mit dem montiertem Ventildeckel in einer Geschlossenstellung des Ventilverschlussbalkens; und
- Fig. 8c: eine seitliche Querschnittsansicht durch ein Lagerelement auf das Klappen-Transferventil mit dem montiertem Ventildeckel in einer Geschlossenstellung des Ventilverschlussbalkens.

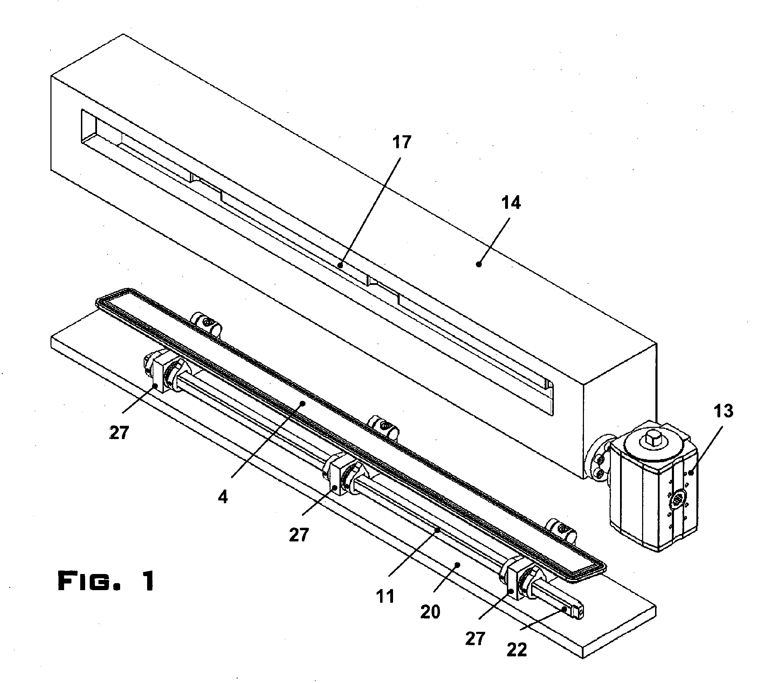

Die Figuren 1 bis 8c zeigen eine gemeinsame, exemplarische Ausführungsform eines erfindungsgemässen Klappen-Transferventils in unterschiedlichen Zuständen, aus unterschiedlichen Ansichten und in unterschiedlichen Detaillierungsgraden. Daher werden diese Figuren gemeinsam beschrieben, wobei zum Teil auf bereits in vorangegangenen Figuren erläuterte Bezugszeichen und Merkmale nicht erneut eingegangen wird.

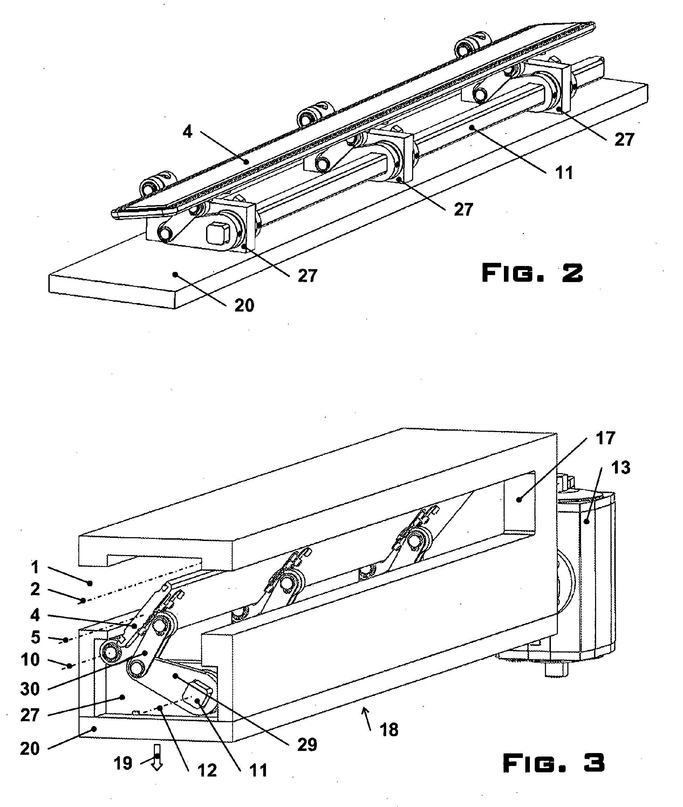

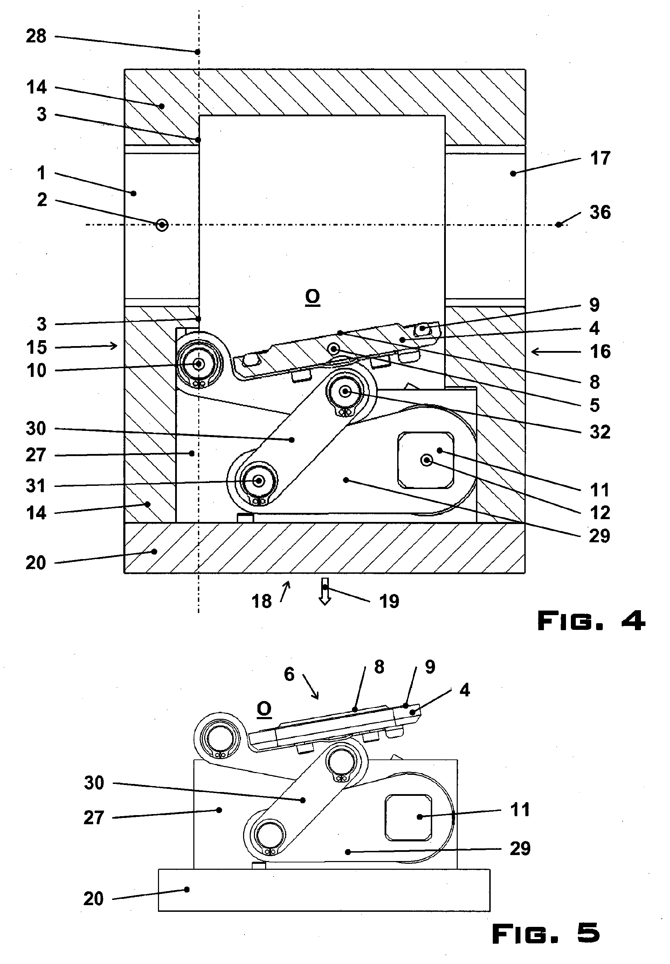

Das Klappen-Transferventil für den Transfer von Halbleiterelementen oder Substraten in eine gasdicht isolierbare Halbleiter- oder Substratbearbeitungs-Prozesskammer hat ein gasdichtes Ventilgehäuse 14, das die Grundform eines Quaders aufweist, der sich aus vier langgestreckten Rechtecken und zwei im nahezu quadratischen, kleinen Rechtecken zusammensetzt. Zwei gegenüberliegende seitliche langgestreckte Seiten bilden eine erste Öffnungsseite 15 und eine zweite Öffnungsseite 16 des Ventilgehäuses 14. Die in den Figuren untere langgestreckte Seite wird als die Seitenwand 18 bezeichnet, wie in Figur 4 gezeigt. Auf der ersten Öffnungsseite 15 des Ventilgehäuses 14 ist eine langgestreckte, schlitzartige erste Öffnung 1 ausgeformt, welche einen rechteckigen Querschnitt aufweist, wie in den Figuren 3 und 4 ersichtlich. Der ersten Öffnung 1 liegt einer zweiten Öffnung 17 gegenüber, die sich auf der zweiten Öffnungsseite 16 des Ventilgehäuses 14 befindet. Die beiden Öffnungen 1 und 17 haben im Wesentlichen den gleichen langgestreckten, schlitzartigen Querschnitt und fluchten in ihrer Projektion. In anderen Worten weisen die beiden Öffnungen 1 und 17 eine gemeinsame Öffnungsachse 36 auf. Die erste Öffnung 1 erstreckt sich entlang einer ersten Längsachse 2 und ist von einer ersten Dichtfläche 3 rahmenförmig umschlossen, wie in Figur 4 gezeigt. Die erste Dichtfläche 3 verläuft in einer Ebene 28 und bildet einen ebenen, in das Ventilinnere weisenden Ventilsitz.

Im Ventilgehäuse ist ein langgestreckter Ventilverschlussbalken 4 angeordnet, der sich entlang einer zur ersten Längsachse 2 im Wesentlichen parallelen zweiten Längsachse 5 erstreckt, wie u. a. in den Figuren 1 und 4 gezeigt. Der Ventilverschlussbalken 4 weist einen Querschnitt auf, der im Wesentlichen den Querschnitten der Öffnungen 1 und 17 entspricht, jedoch etwas grösser ist, so dass er die erste Öffnung 1 überdecken kann.

Im gezeigten Ausführungsbeispiel beträgt die Breite der beiden Öffnungen 1 und 17 sowie des Ventilverschlussbalkens 4 über das Sechsfache der jeweiligen Höhe. Die Querschnitte erstrecken sich somit wesentlich mehr in die Breite, also in die Länge, als in die Höhe, weshalb die Querschnitte als langgestreckt bezeichnet werden.

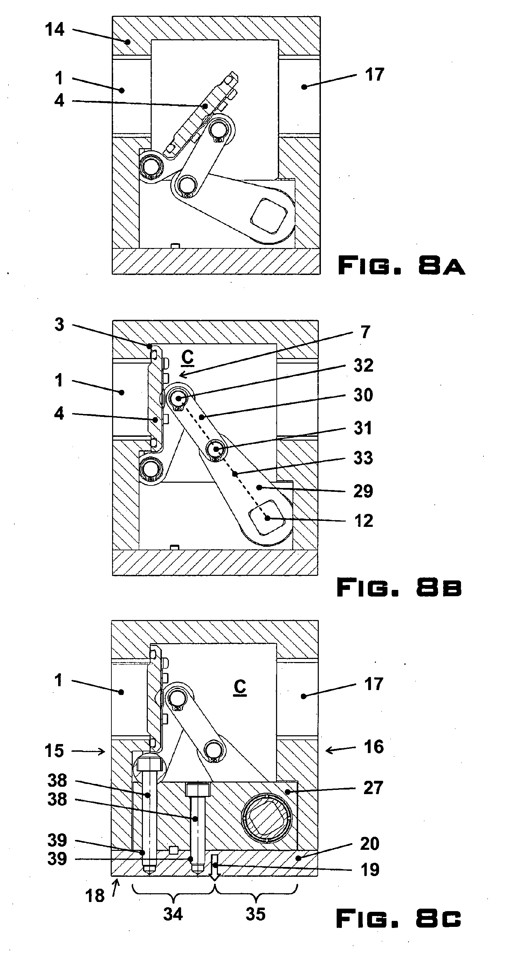

Auf einer Vorderseite 6 des Ventilverschlussbalkens 4 befindet sich eine Verschlussfläche 8 zum Verschliessen der ersten Öffnung 1. Ausserdem ist auf der Verschlussfläche 8 eine zweite Dichtfläche 9 in Form eines O-Rings angeordnet. Der O-Ring 9 korrespondiert mit der ersten Dichtfläche 3, er ist also mit der ersten Dichtfläche 3 in gasdichten Kontakt bringbar, wie in Figur 8a gezeigt.

Die langgestreckte Seitenwand 18 des Ventilgehäuses 14 wird von einem Ventildeckel 20 gebildet, der eine Serviceöffnung 37 gasdicht verschliesst. Der Ventildeckel 20 ist mit dem restlichen Ventilgehäuse 14 gasdicht gekoppelt und ist in eine Seitenrichtung 19, die parallel zu der ersten Öffnungsseite 15 und senkrecht zur Öffnungsachse 36 verläuft, abnehmbar. Der Ventildeckel 20 ist beispielsweise mittels nicht dargestellter Schrauben mit dem restlichen Ventilgehäuse 14 verbunden, wobei eine ebenfalls nicht dargestellte O-Ring-Dichtung zuwischen dem Ventildeckel 20 und dem restlichen Ventilgehäuse 14 für einen gasdichten Verschluss der Serviceöffnung 37 sorgt.

Auf dem Ventildeckel 20 und somit auf der Seitenwand 18 sind mit gleichem Abstand zueinander drei Lagerelemente 27 angeordnet. Die Lagerelemente 27 sind parallel zueinander ausgerichtet und erstrecken sich jeweils im Wesentlichen senkrecht zwischen der ersten Öffnungsseite 15 und der zweiten Öffnungsseite 16 im Ventilgehäuse 14. Die Lagerelemente setzen sich logisch aus zwei Hälften zusammen, nämlich eine zur ersten Öffnungsseite 15 weisenden Hälfte 34 und eine zur zweiten Öffnungsseite 16 weisenden Hälfte 35, wie in den Figuren 4 und 8c gezeigt. Beide Hälften 34 und 35 liegen auf dem Ventildeckel 20 auf. Die Lagerelemente 27 sind auf ihrer zur ersten Öffnungsseite 15 weisenden Hälfte 34 auf dem Ventildeckel 20 fixiert. Hierzu sind jeweils zwei Schrauben 38 auf der zur ersten Öffnungsseite 15 weisenden Hälfte 34 jedes Lagerelementes 27 durch selbiges hindurchgeführt und greifen in Gewindelöcher 39 im Ventildeckel 20 ein. Diese Gewindelöcher 39 sind auf der zur ersten Öffnungsseite 15 weisenden Hälfte des Ventildeckels 20 ausgeformt. Auf diese Weise ist jedes Lagerelement 27 in senkrechter Richtung und in die Seitenrichtung 19 auf dem Ventildeckel 20 fixiert und nach oben unbeweglich. Auf der zur zweiten Öffnungsseite 16 weisenden Hälfte 35 sind die Lagerelemente 27 hingegen in senkrechter Richtung zum Ventildeckel 20 und in Richtung weg von dem Ventildeckel 20, also nach oben, unfixiert und somit im Falle einer Verbiegung des Ventildeckels 20 und/oder der Wand des Ventilgehäuses auf der ersten Öffnungsseite 15 beweglich, wie in Figur 8c gezeigt.

In den Lagerelementen 27 ist eine Welle 11 radial und drehbar gelagert, die um eine zur zweiten Längsachse 5 des Ventilverschlussbalkens 4 im Wesentlichen parallele Wellenachse 12 drehbar ist, wie insbesondere in Figur 1 gezeigt. Die Welle 11 ist also auf dem Ventildeckel 20 drehbar gelagert.

Der Ventilverschlussbalken 4 ist an den Lagerelementen 27 um die gemeinsame Schwenkachse 10 schwenkbar gelagert, wie insbesondere in den Figuren 4, 5 und 8a bis 8c gezeigt. Die Schwenkachse 10 verläuft seitlich zur ersten Öffnung 1, nämlich im Wesentlichen in der Ebene 28 der ersten Dichtfläche 3, wie in Figur 4 dargestellt.

Die schwenkbare Lagerung des Ventilverschlussbalkens 4 um die zur zweiten Längsachse 5 im Wesentlichen parallele Schwenkachse 10 bildet funktional eine Schwenklagerung, mittels welcher der Ventilverschlussbalken 4 um die Schwenkachse 10 zwischen einer Geschlossenstellung C, Figur 8b und 8c, und einer Offenstellung O, Figur 4 mit einem Schwenkwinkel von etwa 90° schwenkbar ist. In der Geschlossenstellung C, Figuren 8b und 8c, überdeckt der Ventilverschlussbalken 4 mit der Verschlussfläche 8 die erste Öffnung 1 und verschliesst sie. In dieser Geschlossenstellung C stehen die erste Dichtfläche 3 und die zweite Dichtfläche 9 in gasdichtem Kontakt miteinander. In der Offenstellung O ist der Ventilverschlussbalken 4 von der ersten Öffnung 1 weggeschwenkt und gibt die erste Öffnung 1 frei.

Die Wellenachse 12 verläuft in Richtung senkrecht zur Ebene 28 der ersten Dichtfläche 3 von der Schwenkachse 10 beabstandet. Die Schwenkachse 10 verläuft durch die zur ersten Öffnungsseite 15 weisenden Hälfte 34 der Lagerelemente 27, wohingegen die Wellenachse 12 durch die zur zweiten Öffnungsseite 16 weisenden Hälfte 35 der Lagerelemente 27 läuft, wie aus Figur 4 ersichtlich.

Im Bereich der Lagerelemente 27 ist an der Welle 11 jeweils ein erster Arm 29 drehfest angeordnet. Die insgesamt drei ersten Arme 29 verlaufen parallel zueinander und senkrecht zur Wellenachse 12. Durch Drehen der Welle 11 sind die ersten Arme 29 um die Wellenachse 12 schwenkbar.

Den ersten Armen 29 ist jeweils ein zweiter Arm 30 zugeordnet. Der zweite Arm 30 ist auf der Rückseite 7 des Ventilverschlussbalkens 4 um eine zweite Armachse 32, die parallel zur Schwenkachse 10 verläuft, schwenkbar gelagert. Der jeweilige erste Arm 29 und zweite Arm 30 sind an ihren freien Enden um eine zur zweiten Armachse 32 im Wesentlichen parallele erste Armachse 31 gelenkig miteinander verbunden. Die Welle 11, die ersten Arme 29 und die zweiten Arme 30 bilden somit einen Hebelantrieb. Somit steht der jeweilige erste Arm 29 über den zweiten Arm 30 mit der Rückseite 7 des Ventilverschlussbalkens 4 derart in Eingriff, dass durch Drehen der Welle 11 und somit durch Schwenken der ersten Arme 29 um die Wellenachse 12 eine Kraft auf die Rückseite 7 des Ventilverschlussbalkens 4 zum Schwenken des Ventilverschlussbalkens 4 um die Schwenkachse 10 zwischen der Offenstellung O und der Geschlossenstellung C aufbringbar ist.

Die Längen der ersten Arme 29 und der zweiten Arme 30 und die Abstände der gemeinsamen Wellenachse 12, der gemeinsamen ersten Armachse 31 und der gemeinsamen zweiten Armachse 32 sind derart, dass die Wellenachse 12, die erste Armachse 31 und die zweite Armachse 32 in der Geschlossenstellung C im Wesentlichen in einer gemeinsamen Ebene 33 liegen, wie in Figur 8b gezeigt, und sich die ersten Arme 29 und die zweiten Arme 30 im Wesentlichen in Totpunktausrichtung befinden.

Die um die Wellenachse 12 drehbare Welle 11 steht über die Arme 29 und 30 also in derartiger Wirkverbindung zu dem Ventilverschlussbalken 4, dass ein Drehen der Welle 11 um die Wellenachse 12 ein Schwenken des Ventilverschlussbalkens 4 um die Schwenkachse 10 bewirkt.

Der Ventilverschlussbalken 4, die Schwenklagerung in Form der Lagerelemente, die Arme 29 und 30 sowie die Welle 11 sind im Ventilgehäuse 14 auf dem Ventildeckel 20 in Form einer Einheit derart angeordnet, dass durch Entkoppeln und Entfernen des Ventildeckels 20 in die Seitenrichtung 19 die Welle 11, die Lagerelemente 27, die Arme 29 und 30 sowie der Ventilverschlussbalken 4 vom Ventilgehäuse 14 als eine gemeinsame Einheit entkoppelbar sind. Diese Elemente bilden somit eine von restlichen Ventilgehäuse 14 entkoppelbare gemeinsame Einheit auf dem Ventildeckel 20, wie in den Figuren 1, 2 und 5 gezeigt. Somit ist ein Wartung dieser Elemente oder ein Austausch der gesamten in den Figuren 2 und 5 gezeigten Einheit möglich.

Zum Drehen der Welle 11 und zum Verstellen des Ventilverschlussbalkens 4 zwischen der Offenstellung O und der Geschlossenstellung C ist ein Antrieb 13 in Form eines Elektromotors seitlich am Ventilgehäuse 14 auf einem vom Ventildeckel 20 entkoppelten Abschnitt des Ventilgehäuses 14 angeordnet. Zwischen der Welle 11 und dem Antrieb 13 befindet sich eine in die Seitenrichtung 19 lösbare Kupplung 21, die derart ausgebildet ist, dass die Welle 11 vom Antrieb 13 zum Abnehmen des Ventildeckels 20 entkoppelbar ist.

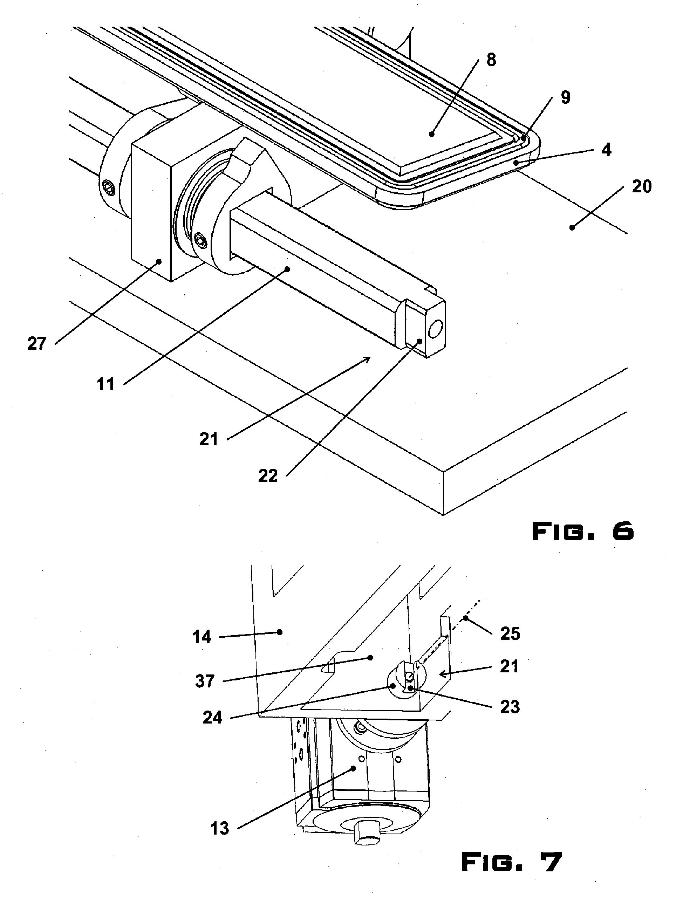

Diese Kupplung 21 ist in den Figuren 6 und 7 gezeigt. Die Kupplung 21 wird von einem ersten Abschnitt 22 der Welle 11 und einem mit dem ersten Abschnitt 22 in Formschluss gekoppelten zweiten Abschnitt 23 einer Antriebswelle 24 des Antriebs 13 gebildet.

Die Antriebswelle 24 ist gasdicht aus dem Ventilgehäuse 14 herausgeführt und wird vom Antrieb 13, der aussen am Ventilgehäuse 14 montiert ist, angetrieben, wie in Figur 7 gezeigt. Die Wellenachse 12 und die Antriebswellenachse 25 der Antriebswelle 24 verlaufen kollinear zueinander und bilden somit eine gemeinsame Achse, wenn der Ventildeckel 20 auf dem Ventilgehäuse 14 montiert ist.

Der erste Abschnitt der Welle 11 wird von einem Ende der Welle 11 gebildet, wobei das Ende der Welle 11 eine erste Ausformung 22, die sich in einer Grundstellung der Welle 11 zumindest teilweise senkrecht zur Wellenachse 12 und in die Seitenrichtung 19 erstreckt, aufweist. Die erste Ausformung hat die Form eines Keils 22 am Ende der Welle 11, wie in Figur 6 gezeigt. Das Ende der Antriebswelle 24 stellt den zweiten Abschnitt 23 der Antriebswelle 24 dar. Das Ende der Antriebswelle 24 hat eine zweite Ausformung 23, die sich in der Grundstellung der Welle 11 zumindest teilweise senkrecht zur Antriebswellenachse 25 und in die Seitenrichtung 19 erstreckt. Die zweite Ausformung 23 korrespondiert mit der ersten Ausformung 22 zur Herstellung des Formschlusses, indem die zweite Ausformung die Form einer Nut 23 hat, in welche der Keil 22 formschlüssig zur Übertragung eines Drehmoments von dem Antrieb 13 auf die Welle 11 eingreift, wenn der Ventildeckel 20 am Ventilgehäuse 14 montiert ist. Dieser Formschluss ist durch das Entfernen des Ventildeckels 20 in die Seitenrichtung 19 auflösbar. Hierzu erstrecken sich der Keil 22 und die Nut 23 in der in den Figuren 4 bis 7 gezeigten Grundstellung der Welle 11 senkrecht zur Wellenachse 12 und in die Seitenrichtung 19. Die Grundstellung der Welle 11 ist diejenige Stellung, in welcher sich der Ventilverschlussbalken in Offenstellung O befindet, wie in den Figuren 4 bis 7 veranschaulicht.

Alternativ besteht jedoch auch die Möglichkeit, dass der Antrieb 13 mit dem Ventildeckel 20 gekoppelt ist, so dass er gemeinsam mit dem Ventildeckel 20 vom Ventilgehäuse 14 entkoppelt werden kann. In diesem Fall ist auch der Antrieb 13 Bestandteil der in den Figuren 2 und 5 gezeigten Einheit und somit gemeinsam mit dem Ventildeckel 20 vom restlichen Ventilgehäuse 14 entkoppelbar. Eine Kupplung 21 kann in diesem Falle entfallen und die Welle 11 und die Antriebswelle 24 können fest miteinander verbunden oder einstückig sein. Das in den Figuren 1 bis 8c veranschaulichte und erläuterte konkrete Ausführungsbeispiel dient lediglich zur exemplarischen Veranschaulichung der Erfindungsaspekte anhand schematischer Darstellungen. Selbstverständlich beschränkt sich die Erfindung nicht auf dieses Ausführungsbeispiele und dessen Merkmalskombinationen.

## Patentansprüche

1. Klappen-Transferventil für den Transfer von Halbleiterelementen oder Substraten in eine gasdicht isolierbare Halbleiter- oder Substratbearbeitungs-Prozesskammer, mit
• einer langgestreckten, insbesondere schlitzartigen ersten Öffnung (1), die sich entlang einer ersten Längsachse (2) erstreckt und die von einer ersten Dichtfläche (3) rahmenförmig umschlossen ist,
• einem langgestreckten Ventilverschlussbalken (4),
- der sich entlang einer zur ersten Längsachse (2) im Wesentlichen parallelen zweiten Längsachse (5) erstreckt und
- der auf einer Vorderseite (6) eine Verschlussfläche (8) zum Verschliessen der ersten Öffnung (1) und eine mit der ersten Dichtfläche (3) korrespondierende und mit ihr in gasdichten Kontakt bringbare zweite Dichtfläche (9) aufweist,
• einer Schwenklagerung, mittels welcher der Ventilverschlussbalken (4) um eine zur zweiten Längsachse (5) im Wesentlichen parallele Schwenkachse (10) zwischen
- einer Geschlossenstellung (C), in welcher der Ventilverschlussbalken (4) mit der Verschlussfläche (8) die erste Öffnung (1) überdeckt und verschliesst, und in welcher die erste Dichtfläche (3) und die zweite Dichtfläche (9) in gasdichtem Kontakt stehen, und
- einer Offenstellung (O), in welcher der Ventilverschlussbalken (4) von der ersten Öffnung (1) weggeschwenkt ist und die erste Öffnung (1) freigibt, insbesondere mit einem Schwenkwinkel von 60° bis 105° schwenkbar ist,
• einer Welle (11), die um eine zur zweiten Längsachse (5) im Wesentlichen parallele Wellenachse (12) drehbar ist und die in derartiger Wirkverbindung zu dem Ventilverschlussbalken (4) steht, dass ein Drehen der welle (11) um die Wellenachse (12) ein Schwenken des Ventilverschlussbalkens (4) um die Schwenkachse (10) bewirkt, und
• mindestens einem Antrieb (13), der mit der Welle (11) zum Drehen der Welle (11) und Verstellen des Ventilverschlussbalkens (4) zwischen der Offenstellung (O) und der Geschlossenstellung (C) gekoppelt ist,
**gekennzeichnet durch**
ein gasdichtes Ventilgehäuse (14) mit
• der ersten Öffnung (1) auf einer ersten Öffnungsseite (15) des Ventilgehäuses (14) und
• einer der ersten Öffnung (1) gegenüberliegenden zweiten öffnung (17) auf einer der ersten Öffnungsseite (15) gegenüberliegenden zweiten öffnungsseite (16) des Ventilgehäuses (14),
wobei
• der Ventilverschlussbalken (4), die Schwenklagerung und die Welle (11) im Ventilgehäuse (14) angeordnet sind
• das Ventilgehäuse (14) auf einer langgestreckten Seitenwand (18) einen mit dem restlichen Ventilgehäuse (14) gasdicht gekoppelten, in eine Seitenrichtung (19) parallel zu der ersten Öffnungsseite (15) abnehmbaren Ventildeckel (20) aufweist,
• die Welle (11) auf dem Ventildeckel (20) drehbar gelagert ist,
• die Schwenklagerung, die Welle (11) und der Ventilverschlussbalken (4) derart auf dem ventildeckel (20) angeordnet sind, dass **durch** Entkoppeln und Entfernen des Ventildeckels (20) in die Seitenrichtung (19) die Welle (11), die Schwenklagerung und der Ventilverschlussbalken (4) vom Ventilgehäuse (14) entkoppelbar sind,
• der Antrieb (13) auf einem vom Ventildeckel (20) entkoppelten Abschnitt des Ventilgehäuses (14) angeordnet ist und
• zwischen der Welle (11) und dem Antrieb (13) eine in die Seitenrichtung (19) lösbare Kupplung (21) angeordnet ist, die derart ausgebildet ist, dass die Welle (11) vom Antrieb (13) zum Abnehmen des Ventildeckels (20) entkoppelbar ist.

2. Klappen-Transferventil nach Anspruch 1, wobei
• die Kupplung (21) von einem ersten Abschnitt (22) der Welle (11) und einem mit dem ersten Abschnitt (22) in Formschluss gekoppelten zweiten Abschnitt (23) einer Antriebswelle (24) des Antriebs (13) gebildet wird, wobei der Formschluss durch das Entfernen des Ventildeckels (20) in die Seitenrichtung (19) auflösbar ist.

3. Klappen-Transferventil nach Anspruch 2, wobei
• die Wellenachse (12) und eine Antriebswellenachse (25) der Antriebswelle (24) parallel zueinander verlaufen oder kollinear sind,
• der erste Abschnitt der Welle (11) von einem Ende der Welle (11) gebildet wird, wobei das Ende der Welle (11) eine erste Ausformung (22), die sich in einer Grundstellung der Welle (11) zumindest teilweise senkrecht zur Wellenachse (12) und in die Seitenrichtung (19) erstreckt, aufweist, und
• der zweite Abschnitt der Antriebswelle (24) von einem Ende der Antriebswelle (24) gebildet wird, wobei das Ende der Antriebswelle (24) eine zweite Ausformung (23), die sich in der Grundstellung der Welle (11) zumindest teilweise senkrecht zur Antriebswellenachse (25) und in die Seitenrichtung (19) erstreckt und mit der ersten Ausformung (22) zur Herstellung des Formschlusses korrespondiert, aufweist.

4. Klappen-Transferventil nach Anspruch 3, wobei die erste Ausformung (22) und die zweiten Ausformung (23) als eine Nut und ein Keil am Ende der Welle (11) und der Antriebswelle (24) ausgebildet sind.

5. Klappen-Transferventil nach einem der Ansprüche 2 bis 4, wobei die Antriebswelle (24) gasdicht aus dem Ventilgehäuse (14) herausgeführt ist und der Antrieb (13) aussen am Ventilgehäuse (14) angeordnet ist.

6. Klappen-Transferventil nach einem der Ansprüche 1 bis 5, wobei
• der Ventilverschlussbalken (4) an mindestens einem mit der Welle (11) drehfest verbundenen Arm angeordnet ist,
• die Schwenkachse (10) und die Wellenachse (12) kollinear sind und
• die Schwenklagerung des Ventilverschlussbalkens (4) von der verdrehbaren Welle (11) und dem mindestens einem Arm gebildet wird.

## Claims

1. Flap transfer valve for transferring semiconductor elements or substrates into a process chamber which is intended for processing semiconductors or substrates and can be insulated in a gas-tight manner, having
• an elongate, in particular slot-like first opening (1), which extends along a first longitudinal axis (2) and is enclosed in a frame-like manner by a first sealing surface (3),
• an elongate valve closure beam (4),
- which extends along a second longitudinal axis (5), essentially parallel to the first longitudinal axis (2), and
- which, on a front side (6), has a closure surface (8) for closing the first opening (1) and also has a second sealing surface (9), which corresponds with the first sealing surface (3) and can be brought into gas-tight contact therewith,
• a pivot-bearing means, by way of which the valve closure beam (4) can be pivoted, in particular by a pivoting angle of 60° to 105°, about a pivot axis (10), essentially parallel to the second longitudinal axis (5), between
- a closed position (C), in which the valve closure beam (4) covers over, and closes, the first opening (1) by way of the closure surface (8), and in which the first sealing surface (3) and the second sealing surface (9) are in gas-tight contact, and
- an open position (O), in which the valve closure beam (4) has been pivoted away from the first opening (1) and frees the first opening (1),
• a shaft (11), which can be rotated about a shaft axis (12), essentially parallel to the second longitudinal axis (5), and is operatively connected to the valve closure beam (4) such that rotation of the shaft (11) about the shaft axis (12) causes the valve closure beam (4) to pivot about the pivot axis (10), and
• at least one drive (13), which is coupled to the shaft (11) in order to rotate the shaft (11) and to adjust the valve closure beam (4) between the open position (0) and the closed position (C),
**characterized by**
a gas-tight valve housing (14) having
• the first opening (1) on a first opening side (15) of the valve housing (14), and
• a second opening (17), located opposite the first opening (1), on a second opening side (16) of the valve housing (14), said second opening side being located opposite the first opening side (15),
wherein
• the valve closure beam (4), the pivot-bearing means and the shaft (11) are arranged in the valve housing (14),
• the valve housing (14), on an elongate side wall (18), has a valve cover (20), which is coupled in a gas-tight manner to the rest of the valve housing (14) and can be removed in a lateral direction (19) parallel to the first opening side (15),
• the shaft (11) is mounted in a rotatable manner on the valve cover (20),
• the pivot-bearing means, the shaft (11) and the valve closure beam (4) are arranged on the valve cover (20) such that, by virtue of the valve cover (20) being uncoupled and removed in the lateral direction (19), the shaft (11), the pivot-bearing means and the valve closure beam (4) can be uncoupled from the valve housing (14),
• the drive (13) is arranged on a portion of the valve housing (14) which is uncoupled from the valve cover (20), and
• a coupling (21) which can be released in the lateral direction (19) is arranged between the shaft (11) and the drive (13) and is designed such that the shaft (11) can be uncoupled from the drive (13) in order for the valve cover (20) to be removed.

2. Flap transfer valve according to Claim 1, wherein
• the coupling (21) is formed by a first portion (22) of the shaft (11) and a second portion (23) of a driveshaft (24) of the drive (13), said second portion being coupled to the first portion (22) with a form fit, wherein the form fit can be disengaged by virtue of the valve cover (20) being removed in the lateral direction (19).

3. Flap transfer valve according to Claim 2, wherein
• the shaft axis (12) and a driveshaft axis (25) of the driveshaft (24) run parallel to one another or are collinear,
• the first portion of the shaft (11) is formed by one end of the shaft (11), wherein the end of the shaft (11) has a first shaped structure (22), which, in a basic position of the shaft (11), extends at least partially perpendicularly to the shaft axis (12) and in the lateral direction (19), and
• the second portion of the driveshaft (24) is formed by one end of the driveshaft (24), wherein the end of the driveshaft (24) has a second shaped structure (23), which, in the basic position of the shaft (11), extends at least partially perpendicularly to the driveshaft axis (25) and in the lateral direction (19), and which corresponds with the first shaped structure (22) in order to establish the form fit.

4. Flap transfer valve according to Claim 3, wherein the first shaped structure (22) and the second shaped structure (23) are designed in the form of a groove and a spline at the end of the shaft (11) and the end of the driveshaft (24).

5. Flap transfer valve according to one of Claims 2 to 4,
wherein the driveshaft (24) is guided in a gas-tight manner out of the valve housing (14) and the drive (13) is arranged on the outside of the valve housing (14).

6. Flap transfer valve according to one of Claims 1 to 5, wherein
• the valve closure beam (4) is arranged on at least one arm connected in a rotationally fixed manner to the shaft (11),
• the pivot axis (10) and the shaft axis (12) are collinear, and
• the pivot-bearing means of the valve closure beam (4) is formed by the rotatable shaft (11) and the at least one arm.

## Revendications

1. Soupape de transfert à clapets pour le transfert d'éléments semiconducteurs ou de substrats dans une chambre de traitement de semiconducteurs ou de substrats pouvant être isolée étanche au gaz avec
• une première ouverture (1) allongée, en particulier de type fente, qui s'étend le long d'un premier axe longitudinal (2) et qui est enserrée en forme de cadre par une première surface d'étanchéité (3),
• une barre de fermeture de soupape allongée (4)
- qui s'étend le long d'un second axe longitudinal (5) substantiellement parallèle au premier axe longitudinal (2) et
- qui présente, sur un côté avant (6), une surface de fermeture (8) pour fermer la première ouverture (1) et une seconde surface d'étanchéité (9) qui correspond à la première surface d'étanchéité (3) et qui peut être amenée en contact étanche au gaz avec elle,
• un palier de pivotement au moyen duquel la barre de fermeture de soupape (4) est pivotante autour d'un axe de pivotement (10) substantiellement parallèle au second axe longitudinal (5) entre
- une position fermée (C) dans laquelle la barre de fermeture de soupape (4) recouvre et ferme la première ouverture (1) avec la surface de fermeture (8) et dans laquelle la première surface d'étanchéité (3) et la seconde surface d'étanchéité (9) sont en contact étanche au gaz et
- une position ouverte (O) dans laquelle la barre de fermeture de soupape (4) est éloignée par pivotement de la première ouverture (1) et qui libère la première ouverture (1),
en particulier avec un angle de pivotement de 60° à 105°,
• un arbre (11) qui est rotatif autour d'un axe d'arbre (12) substantiellement parallèle au second axe longitudinal (5) et qui est en relation fonctionnelle telle avec la barre de fermeture de soupape (4) qu'une rotation de l'arbre (11) autour de l'axe d'arbre (12) provoque un pivotement de la barre de fermeture de soupape (4) autour de l'axe de pivotement (10) et
• au moins un entraînement (13) qui est couplé avec l'arbre (11) pour tourner l'arbre (11) et ajuster la barre de fermeture de soupape (4) entre la position ouverte (O) et la position fermée (C),
**caractérisée par**
un boîtier de soupape étanche au gaz (14) avec
• la première ouverture (1) sur un premier côté d'ouverture (15) du boîtier de soupape (14) et
• une seconde ouverture (17) en face de la première ouverture (1) sur un second côté d'ouverture (16) du boîtier de soupape (14) qui est en face du premier côté d'ouverture (15),
cependant que
• la barre de fermeture de soupape (4), le palier de pivotement et l'arbre (1) sont placés dans le boîtier de soupape (14),
• le boîtier de soupape (14) présente, sur une paroi latérale allongée (18), un couvercle de soupape amovible (20) couplé étanche au gaz avec le reste du boîtier de soupape (14), pouvant être ôté dans un sens latéral (19) parallèlement au premier côté d'ouverture (15),
• l'arbre (11) est positionné rotatif sur le couvercle de soupape (20),
• le palier de pivotement, l'arbre (11) et la barre de fermeture de soupape (4) sont placés sur le couvercle de soupape (20) de manière telle qu'en désaccouplant et en enlevant le couvercle de soupape (20) dans le sens latéral (19) l'arbre (11), le palier de pivotement et la barre de fermeture de soupape (4) peuvent être désaccouplés du boîtier de soupape (14),
• l'entraînement (13) est placé sur une section du boîtier de soupape (14) qui est désaccouplée du couvercle de soupape (20) et
• un couplage (21) détachable dans le sens latéral (19) est placé entre l'arbre (11) et l'entraînement (13), couplage qui est configuré tel que l'arbre (11) peut être désaccouplé de l'entraînement (13) pour enlever le couvercle de soupape (20).

2. Soupape de transfert à clapets selon la revendication 1,
• le couplage (21) étant formé par une première section (22) de l'arbre (11) et une seconde section (23) d'un arbre d'entraînement (24) de l'entraînement (13) qui est couplée de manière crabotée avec la première section (22), la fermeture crabotée pouvant être débloquée en enlevant le couvercle de soupape (20) dans le sens latéral (19).

3. Soupape de transfert à clapets selon la revendication 2,
• l'axe d'arbre (12) et un axe d'arbre d'entraînement (25) de l'arbre d'entraînement (24) étant parallèles l'un à l'autre ou colinéaires,
• la première section de l'arbre (11) étant formée par une extrémité de l'arbre (11), l'extrémité de l'arbre (11) présentant une première conformation (22) qui s'étend dans une position de base de l'arbre (11) au moins partiellement perpendiculairement à l'axe d'arbre (12) et dans le sens latéral (19) et
• la seconde section de l'arbre d'entraînement (24) est formée par une extrémité de l'arbre d'entraînement (24), cependant que l'extrémité de l'arbre d'entraînement (24) présente une seconde conformation (23) qui s'étend dans la position de base de l'arbre (11) au moins partiellement perpendiculairement à l'axe d'arbre d'entraînement (25) et dans le sens latéral (19) et qui correspond à la première conformation (22) pour réaliser la fermeture crabotée.

4. Soupape de transfert à clapets selon la revendication 3, la première conformation (22) et la seconde conformation (23) étant configurées comme une rainure et une clavette à l'extrémité de l'arbre (11) et de l'arbre d'entraînement (24).

5. Soupape de transfert à clapets selon l'une des revendications 2 à 4, l'arbre d'entraînement (24) étant sorti étanche au gaz du boîtier de soupape (14) et l'entraînement (13) étant placé à l'extérieur sur le boîtier de soupape (14).

6. Soupape de transfert à clapets selon l'une des revendications 1 à 5,
• la barre de fermeture de soupape (4) étant placée sur au moins un bras relié à l'arbre (11) en étant résistant à la torsion,
• l'axe de pivotement (10) et l'axe d'arbre (12) étant colinéaires et
• le palier de pivotement de la barre de fermeture de soupape (4) étant formé par l'arbre qui peut tourner (11) et par l'arbre qui existe au moins.
